# EUROPEAN PATENT SPECIFICATION

(11) **EP 4 325 663 B1**
(45) Date of publication and mention of the grant of the patent: **14.10.2026**
(21) Application number: 22787484.9
(22) Date of filing: 11.04.2022
(51) Int. Cl.: G01S 7/03, H01Q 1/52, H01Q 17/00, H01Q 1/32, H01Q 11/04

(54) **DETECTION APPARATUS, RADOME, MILLIMETER-WAVE RADAR AND TERMINAL DEVICE**
DETEKTIONSVORRICHTUNG, RADOM, MILLIMETERWELLENRADAR UND ENDGERÄTEVORRICHTUNG
APPAREIL DE DÉTECTION, RADÔME, RADAR À ONDES MILLIMÉTRIQUES ET DISPOSITIF TERMINAL

(30) Priority: 15.04.2021 CN 202110405826
(43) Date of publication of application: 21.02.2024
(73) Proprietor: Yinwang Intelligent Technologies Co., Ltd., Shenzhen, Guangdong 518129 (CN)
(72) Inventor: ZHOU, Bin, Shenzhen, Guangdong 518129 (CN); XIE, Chao, Shenzhen, Guangdong 518129 (CN); SHU, Qiwei, Shenzhen, Guangdong 518129 (CN); ZHAO, Sheng, Shenzhen, Guangdong 518129 (CN)
(74) Representative: Pfenning, Meinig & Partner mbB
(86) International application number: PCT/CN2022/086119
(87) International publication number: WO 2022/218258

(56) References cited:
- CN-A- 110 797 664
- CN-A- 111 900 548
- CN-A- 112 271 461
- CN-A- 112 398 497
- CN-U- 212 209 738
- JP-A- 2010 210 297
- US-A- 3 325 808
- US-A1- 2014 246 608
- US-A1- 2020 243 960

## Description

Priority is claimed to Chinese Patent Application No. 202110405826.6, filed with the China National Intellectual Property Administration on April 15, 2021 and entitled "DETECTION APPARATUS, RADOME, MILLIMETER-WAVE RADAR, AND TERMINAL DEVICE".

### TECHNICAL FIELD

This technical description generally relates to the radio frequency field, and the invention specifically relates to a detection apparatus and a millimeter-wave radar to which the detection apparatus is applied.

### BACKGROUND

A continuous wave radar adopts a design of separating a transmit antenna from a receive antenna, which can realize continuous transmission and reception of signals. In this way, the following outstanding problems of a conventional pulse radio frequency apparatus are overcome. For example, the conventional pulse radio frequency apparatus has problems such as a large size, a high required transmit power, a switching time required for transmission and reception, and a detection dead zone.

At present, the continuous wave radar tends to use a multiple-input multiple-output (MIMO) radar system, and a plurality of channels of the continuous wave radar work concurrently. Therefore, one of key objectives is to improve isolation between channels, avoid mutual interference between the channels, and increase an amount of MIMO system information. Further, a detection apparatus applied in fields such as vehicle driving and road surveillance is implemented by widely using a radio frequency chip and an antenna array. However, a development cycle of the radio frequency chip is long, and it is usually difficult to quickly improve isolation through iteration. Therefore, improving isolation between channels of the detection apparatus by using an external structure design becomes an important technology in hardware design.

In the conventional technology, the following solutions are provided to reduce interference between a receive channel and a transmit channel of the radar.

In a first solution, a distance between the transmit antenna and the receive antenna is increased in physical space. This solution can improve isolation between the transmit antenna and the receive antenna in a simple manner.

In a second solution, an electromagnetic band gap (EBG) cycle structure is provided. This solution is mainly used to suppress a surface current between the transmit antenna and the receive antenna.

In a third solution, a metal isolation apparatus is added. For example, the metal isolation apparatus may be a radome, and an isolation tube is sleeved on an outer wall of the radome. The isolation tube is an integrated isolation tube, or the isolation tube is a split-type isolation tube formed by block units. The isolation tube can improve isolation between the transmit antenna and the receive antenna without increasing a spacing between the transmit antenna and the receive antenna. A key part is the isolation tube that uses a light metal aluminum plate, to improve isolation between the transmit antenna and the receive antenna and avoid mutual interference and coupling between signals of the transmit antenna and the receive antenna.

In a fourth solution, a specific high-isolation antenna is designed. In this solution, from a perspective of antenna design, an antenna array with a specific size and spacing is designed, and a neutralization line, a bridge, a virtual array element, or the like is used to improve isolation between the transmit antenna and the receive antenna.

A basic principle of the foregoing solutions is to prevent mutual transmission of electromagnetic waves to reduce electromagnetic radiation and implement anti-interference. However, these solutions can only limit a propagation path of a leaked electromagnetic wave, but cannot eliminate the leaked electromagnetic wave. As a result, isolation between channels and within a channel is poor, and radar performance deteriorates (for example, a radiation pattern deteriorates) or received noise increases. In addition, a structure of the isolation apparatus in the foregoing solutions has a large size and high costs.

US 2020/0243960 A1 discloses a radome subassembly for a radar sensor for motor vehicles, which radar sensor encompasses a radar-frequency printed circuit board having at least one antenna and a radar-frequency printed circuit alongside the antenna, the radome subassembly encompassing: a radome for covering the antenna side of the radar-frequency printed circuit board, and an absorber for radar waves in order to shield the radar-frequency printed circuit, the absorber being disposed in front of an inner side of the radome, the absorber leaving a region next to the absorber, in front of the inner side of the radome, open for a main antenna lobe of the at least one antenna, the absorber being fastened on the radome, and the radome subassembly having at least one elastic plastic element by way of which the absorber is braced movably against the inner side of the radome. A radar sensor having the radome subassembly is also described.

JP 2010/210297 A aims to provide a wide coverage radar apparatus capable of detecting an object at extremely short-range by reducing interference due to a direct wave reflected by a radome. The proposed wide coverage radar apparatus includes a substrate, and a transmission antenna, and a reception antenna formed on the substrate. The substrate, the transmission antenna, and the reception antenna are entirely covered by the radome. The wide coverage radar apparatus further includes an absorbing body between the transmission antenna and the reception antenna. The absorbing body is provided in order that a high-frequency signal emitted from the transmission antenna, reflected by the inner surface of an upper lid of the radome, and repeating the reflection between the substrate and the upper lid is prevented from sneaking into the reception antenna.

US Patent 3,325,808 addresses the need for an effective radar camouflage system that can attenuate radar energy over a broad frequency range. The document proposes a tunable quarter wave absorber that can adjust its effective electrical thickness to optimize attenuation at various frequencies of impinging radar. This is achieved by varying the distance between a conductive ground plane and a resistive layer using a fluid dielectric material, such as water, which has a high dielectric constant. The distance is adjusted to be an odd multiple of one-quarter of the wavelength of the radar radiation traveling through the dielectric liquid. The system includes means for detecting the frequency of the incident radar and automatically adjusting the thickness of the absorber to match the desired attenuation frequency. Hence, this design allows for a lightweight, adaptable radar attenuator that can be tuned to provide optimal attenuation across a broad range of frequencies, making it suitable for modern radar camouflage applications.

CN 110 797 664 A describes an adjustable coding basic unit with dual functions and a metasurface, and belongs to the field of electromagnetic materials. The document also describes an adjustable coding basic unit with dual functions, which is used for forming a meta surface and comprises a metal patch, a dielectric substrate, a water matrix layer and a metal grounding plate. The document further describes a meta surface which comprises N*N adjustable coding basic units with dual functions, the adjustable coding basic units are arranged in an N*N square matrix, and N is a non-zero positive integer. Because the meta surface is provided with an aqueous medium layer with adjustable salinity, the meta surface can modulate the resonance state of the coding unit and further achieve dual functions of low-frequency radiation field and high-frequency absorption characteristic in a frequency domain.

### SUMMARY

In view of this, the object of the present invention is to provide a detection apparatus which can reduce, at low costs, at least interference caused by energy leaked by a radio frequency chip to a channel without obviously increasing an overall volume of the detection apparatus. Further, a millimeter-wave radar is desired, which can also achieve the same beneficial effect. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

Therefore, this invention uses the following technical solutions.

According to a first aspect according to the invention, the invention provides a detection apparatus, including a circuit board and a radio frequency chip, where the radio frequency chip is installed on the circuit board, the circuit board is provided with a transmit antenna, a receive antenna, and a feeder, and the transmit antenna and the receive antenna are connected to the radio frequency chip through the feeder, where the detection apparatus further includes a wave-absorbing component, where the wave-absorbing component and the radio frequency chip are located on a same side of the circuit board; in a first direction perpendicular to the circuit board, the wave-absorbing component covers the radio frequency chip; and the wave-absorbing component includes a peripheral structure and a wave-absorbing medium encircled and accommodated by the peripheral structure, and the wave-absorbing medium includes water.

By using the foregoing technical solutions, the detection apparatus in this application is provided with the wave-absorbing component. The wave-absorbing medium of the wave-absorbing component includes water that has good effect on electromagnetic wave attenuation and has low costs, and the peripheral structure that can accommodate the wave-absorbing medium is small. Therefore, according to the detection apparatus in this application, isolation between a transmit channel and a receive channel can be effectively improved at low costs without obviously increasing an overall volume, to at least avoid unexpected impact on the transmit channel and the receive channel caused by energy leaked by the radio frequency chip of the detection apparatus.

According to the first aspect, in a first possible implementation of the detection apparatus, in the first direction, the wave-absorbing component covers a part or all of the feeder.

By using the foregoing technical solutions, the wave-absorbing component of the detection apparatus in this application has a shielding function on the feeder of the detection apparatus, to avoid unexpected impact caused by energy leaked by the feeder on the receive channel and the transmit channel.

According to the first aspect or the first possible implementation of the first aspect, in the first direction, a minimum thickness of the wave-absorbing medium is greater than or equal to 1/2 of a medium wavelength, and the medium wavelength is a wavelength that is of an electromagnetic wave transmitted by the detection apparatus and that is in the circuit board.

By using the foregoing technical solutions, the wave-absorbing component in this application has a sufficient thickness, so that the wave-absorbing component can effectively absorb and attenuate energy leaked by the detection apparatus.

According to the first aspect, or the first possible implementation of the first aspect, or any implementation based on the first possible implementation, in the first direction, a maximum distance between outer surfaces that are of the wave-absorbing medium and the circuit board and that face each other is less than or equal to 1/4 of the medium wavelength.

By using the foregoing technical solution, it is ensured that the wave-absorbing component can effectively absorb and attenuate energy leaked by the detection apparatus, and the wave-absorbing component does not adversely affect normal working of the detection apparatus (especially the feeder).

According to the first aspect, or the first possible implementation of the first aspect, or any implementation based on the first possible implementation, on any side in a second direction, the outer surface of the wave-absorbing medium exceeds a boundary of the radio frequency chip or the feeder; and/or on any side in a third direction, the outer surface of the wave-absorbing medium exceeds the boundary of the radio frequency chip or the feeder, where the second direction and the third direction are parallel to the circuit board, and the second direction is perpendicular to the third direction.

By using the foregoing technical solutions, the wave-absorbing component in this application has a sufficient length and width, so that the wave-absorbing component can effectively absorb energy leaked by the detection apparatus.

According to the first aspect, or the first possible implementation of the first aspect, or any implementation based on the first possible implementation, the wave-absorbing component is located between the receive antenna and the transmit antenna.

By using the foregoing technical solution, isolation between the transmit antenna and the receive antenna can be effectively improved by using the wave-absorbing component, and unexpected impact caused by energy leaked by the transmit antenna on the receive antenna is mainly prevented.

According to the first aspect, or the first possible implementation of the first aspect, or any implementation based on the first possible implementation, the circuit board includes a plurality of receive antennas and a plurality of transmit antennas; a part of the wave-absorbing component is located between two adjacent receive antennas; and/or a part of the wave-absorbing component is located between two adjacent transmit antennas.

By using the foregoing technical solution, even if the detection apparatus has a plurality of receive antennas and a plurality of transmit antennas, isolation between the transmit antennas, the receive antennas, and/or the receive antennas and the transmit antennas can be effectively improved by using the wave-absorbing component.

According to the first aspect, or the first possible implementation of the first aspect, or any implementation based on the first possible implementation, the peripheral structure is made of a hydrophobic material.

By using the foregoing technical solution, sealing performance of the peripheral structure for the wave-absorbing medium including water is effectively improved.

According to the first aspect, or the first possible implementation of the first aspect, or any implementation based on the first possible implementation, the hydrophobic material includes at least one of the following materials: nitrile-butadiene rubber, polytetrafluoroethylene, and silicon dioxide.

By using the foregoing technical solution, sealing performance of the peripheral structure for the wave-absorbing medium including water is further effectively improved.

According to the first aspect, or the first possible implementation of the first aspect, or any implementation based on the first possible implementation, although not claimed, an inner surface of the peripheral structure undergoes hydrophobic treatment.

By using the foregoing technical solution, sealing performance of the peripheral structure for the wave-absorbing medium including water is further effectively improved.

According to the first aspect, or the first possible implementation of the first aspect, or any implementation based on the first possible implementation, the wave-absorbing medium further includes ethylene glycol.

By using the foregoing technical solution, it can be ensured that the wave-absorbing medium does not freeze in a predetermined low-temperature state, and wave-absorbing performance of the wave-absorbing medium in the low-temperature state can be ensured.

According to the first aspect, or the first possible implementation of the first aspect, or any implementation based on the first possible implementation, the detection apparatus further includes a heat conducting component, the heat conducting component is disposed between the wave-absorbing component and the radio frequency chip, and the heat conducting component is in contact with the radio frequency chip.

By using the foregoing technical solution, heat of the radio frequency chip can be transferred to the wave-absorbing component by using the heat conducting component, thereby improving heat dissipation performance of the radio frequency chip.

According to the first aspect, or the first possible implementation of the first aspect, or any implementation based on the first possible implementation, the heat conducting component includes at least one of a metal sheet and a heat conducting medium.

By using the foregoing technical solution, a capability of transferring heat to the wave-absorbing component by the radio frequency chip through the heat conducting component can be further improved, thereby improving heat dissipation performance of the radio frequency chip.

According to the first aspect, or the first possible implementation of the first aspect, or any implementation based on the first possible implementation, the detection apparatus is a millimeter-wave detection apparatus.

By using the foregoing technical solution, because the wave-absorbing medium including water has particularly good absorption effect on a millimeter wave, better effect can be achieved when an electromagnetic wave applied to the detection apparatus in this application is a millimeter wave.

According to a second aspect, where the second aspect and any of its implementations and options below are not claimed, an embodiment of this application provides a radome, where the radome includes a wave-absorbing component, the wave-absorbing component includes a peripheral structure and a wave-absorbing medium accommodated by the peripheral structure, and the wave-absorbing medium includes water.

According to the foregoing technical solutions, the radome in this application includes the wave-absorbing component, and the wave-absorbing medium of the wave-absorbing component includes water that has good effect on electromagnetic wave attenuation and has low costs. Therefore, the radome according to this application can effectively provide an electromagnetic wave absorption and shielding capability at low costs without increasing an overall volume and greatly changing a structure of the radome.

According to the second aspect, in a first possible but not claimed implementation of the radome, the radome further includes a wave transmission part, and the wave-absorbing component and the wave transmission part are installed in a fastened manner.

According to the foregoing technical solutions, when the radome in this application is applied to an apparatus having a transmit antenna and a receive antenna, the radome in this application does not affect normal operation of the transmit antenna and the receive antenna.

According to the second aspect or the first possible but not claimed implementation of the second aspect, the peripheral structure is made of a hydrophobic material.

By using the foregoing technical solution, sealing performance of the peripheral structure for the wave-absorbing medium including water is effectively improved.

According to the second aspect, or the first possible but not claimed implementation of the second aspect, or any implementation based on the first possible implementation, the hydrophobic material includes at least one of the following materials: nitrile-butadiene rubber, polytetrafluoroethylene, and silicon dioxide.

By using the foregoing technical solution, sealing performance of the peripheral structure for the wave-absorbing medium including water is further effectively improved.

According to the second aspect, or the first possible but not claimed implementation of the second aspect, or any implementation based on the first possible implementation, an inner surface of the peripheral structure undergoes hydrophobic treatment.

By using the foregoing technical solution, sealing performance of the peripheral structure for the wave-absorbing medium including water is further effectively improved.

According to the second aspect, or the first possible but not claimed implementation of the second aspect, or any implementation based on the first possible implementation, the wave-absorbing medium further includes ethylene glycol.

By using the foregoing technical solution, it can be ensured that the wave-absorbing medium does not freeze in a predetermined low-temperature state, and wave-absorbing performance of the wave-absorbing medium in the low-temperature state can be ensured.

According to a third aspect according to the invention, the invention provides a millimeter-wave radar, where the millimeter-wave radar includes the detection apparatus according to any one of the foregoing technical solutions, or includes the radome according to any one of the foregoing technical solutions.

By using the foregoing technical solutions, the millimeter-wave radar in this application can use energy leaked by the wave-absorbing component absorber, to prevent the energy from causing unexpected impact on a transmit channel and a receive channel of the millimeter-wave radar.

According to a fourth aspect, where the fourth aspect and any of its implementations and options below are not claimed, an embodiment of this application provides a terminal device, where the terminal device includes the detection apparatus according to any one of the foregoing technical solutions, or includes the radome according to any one of the foregoing technical solutions.

By using the foregoing technical solutions, the terminal device in this application can use energy leaked by the wave-absorbing component absorber, to prevent the energy from causing unexpected impact on the terminal device.

According to the fourth aspect, in a first possible but not claimed implementation of the terminal device, the terminal device is an intelligent transportation device, a smart home device, an intelligent manufacturing device, an uncrewed aerial vehicle, or a robot.

Various terminal devices to which the technical solutions of this application are applicable are limited by using the foregoing technical solutions.

These aspects and other aspects of this application are more concise and more comprehensive in descriptions of the following (a plurality of) embodiments.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

The accompanying drawings included in this specification and constituting a part of this specification, together with this specification, illustrate example embodiments, features, and aspects of this application, and are used to explain the principles of this application.
FIG. 1 is a three-dimensional schematic diagram of a structure of a detection apparatus according to a first embodiment of this application, where in the figure, another component is accommodated in space encircled by a radome and a base, and is not shown,
FIG. 2 is a schematic top view of the structure of the detection apparatus in FIG. 1 in a perspective manner;
FIG. 3 is a schematic side view of the structure of the detection apparatus in FIG. 1;
FIG. 4 is a schematic top view of a partial structure of the detection apparatus in FIG. 1, where relative positions of a wave-absorbing component and a circuit board are shown;
FIG. 5 is a three-dimensional schematic diagram of the structure shown in FIG. 4;
FIG. 6 is a schematic main view of the structure shown in FIG. 4;
FIG. 7 is a schematic side view of the structure shown in FIG. 4;
FIG. 8 is a schematic bottom view of a partial structure of a detection apparatus according to a second embodiment of this application; and
FIG. 9 is a schematic top view of a partial structure of a detection apparatus according to a second embodiment of this application.

### Description of reference numerals

1: circuit board; 11: transmit antenna; 11a: transmit antenna module; 12: receive antenna; 12a: receive antenna module; 13: feeder;
2: radio frequency chip;
3: wave-absorbing component; 31: peripheral structure; 32: wave-absorbing medium;
4: radome; 41: wave transmission part;
5: heat conducting component;
D1: first direction; D2: second direction; and D3: third direction.

### DESCRIPTION OF EMBODIMENTS

The following describes various example embodiments, features, and aspects of this application in detail with reference to the accompanying drawings. Identical reference numerals in the accompanying drawings indicate elements that have same or similar functions. Although various aspects of embodiments are illustrated in the accompanying drawings, the accompanying drawings are not necessarily drawn in proportion unless otherwise specified.

The specific term "example" herein means "used as an example, embodiment, or illustration". Any embodiment described as "exemplary" is not necessarily explained as being superior or better than other embodiments.

In addition, to better describe this application, numerous specific details are given in the following specific embodiments. A person skilled in the art should understand that this application can still be implemented without some specific details. In some examples, methods, means, and elements that are well-known to a person skilled in the art are not described in detail, so that the subject matter of this application is highlighted.

In this application, unless otherwise specified, a "wavelength" of an electromagnetic wave is a medium wavelength of the electromagnetic wave. For example, the medium wavelength may be a wavelength of the electromagnetic wave in a circuit board, but based on an actual situation, the medium wavelength may alternatively be set to a wavelength of the electromagnetic wave in another medium.

In this application, a "feeder" may be a feed line extending from a radio frequency chip to an antenna module that can receive and transmit an electromagnetic wave, that is, does not include a feeder part that forms the antenna module. The "antenna module" means that a branch on the circuit board is provided with a lead or a cable of an antenna radiation unit. The "antenna radiation unit" is a minimum working unit of a transmit antenna or a receive antenna, and can effectively transmit and receive an electromagnetic wave. In addition, a shape and a size of the feeder are not limited in the solution of this application, and the shape and the size of the feeder in this application may be randomly changed as required.

In this application, unless otherwise specified, "a first direction D1" is a direction perpendicular to the circuit board, and "a second direction D2" and "a third direction D3" are two directions parallel to the circuit board and perpendicular to each other. In a specific embodiment, the "second direction D2" and the "third direction D3" are separately directions extending from two sides perpendicular to each other in a plane of a square circuit board or two directions perpendicular to each other in a plane of a non-square circuit board. The foregoing directions are defined only for ease of describing a structure of a detection apparatus according to this application, and do not impose any limitation on a usage status of the detection apparatus according to this application. In addition, unless otherwise specified, a "channel" refers to a structure of the detection apparatus for receiving and transmitting an electromagnetic wave.

The following describes a structure of a detection apparatus according to a first embodiment of this application with reference to the accompanying drawings.

### (Structure of the detection apparatus according to the first embodiment of this application)

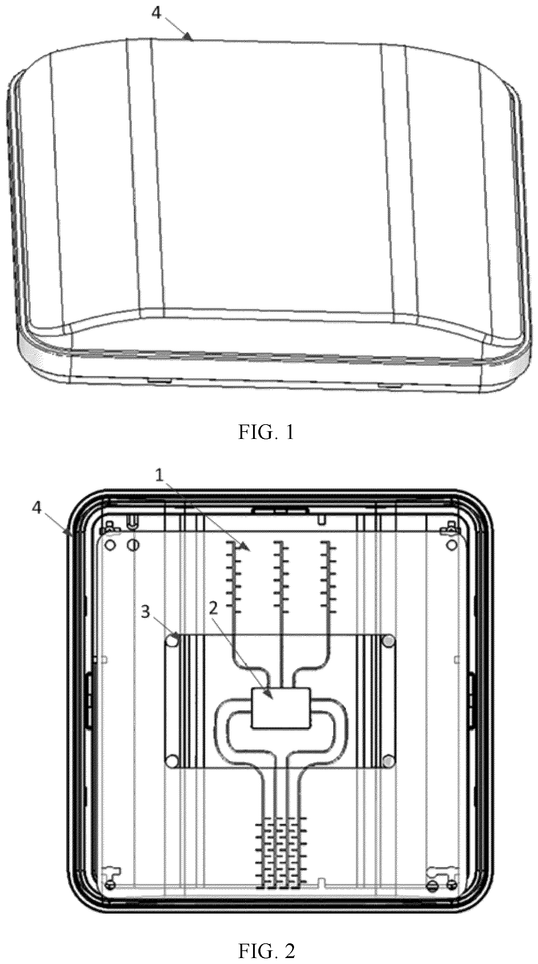

As shown in FIG. 1 to FIG. 7, the detection apparatus according to the first embodiment of this application is an in-vehicle continuous wave radar using a millimeter wave, and the detection apparatus includes a circuit board 1, a radio frequency chip 2, a wave-absorbing component 3, and a radome 4. Further, the detection apparatus may further include a heat conducting component 5.

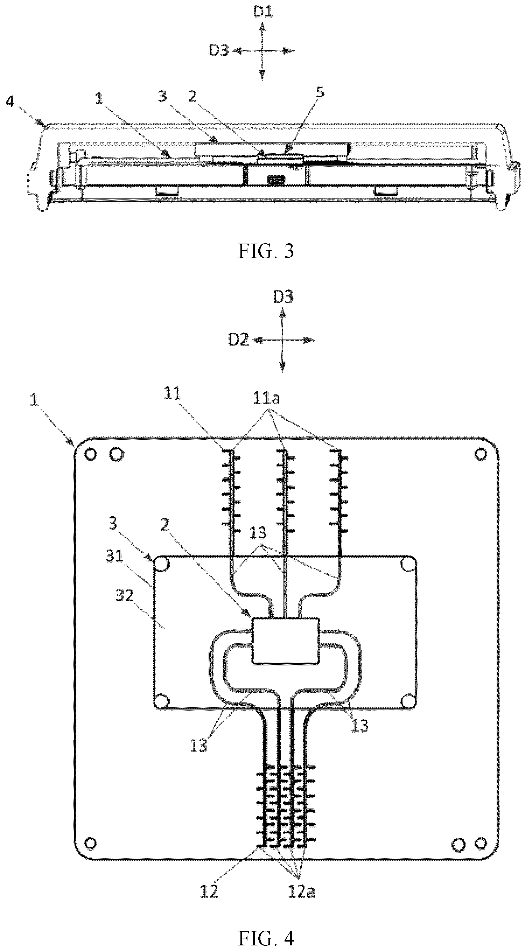

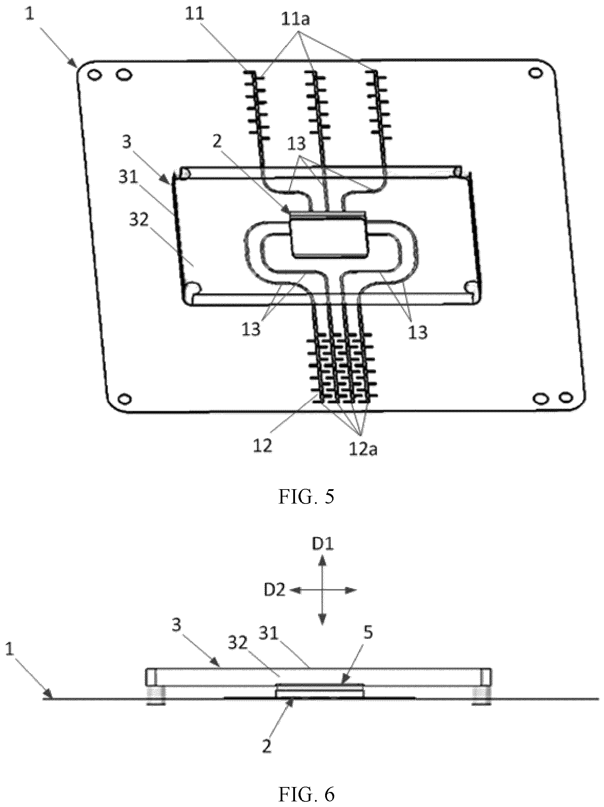

In this embodiment, as shown in FIG. 4 and FIG. 5, the circuit board 1 is a printed circuit board. The entire circuit board 1 has a square shape, for example, a rectangle or a square. This is not specifically limited in this application. The circuit board 1 is provided with a chip installation part for installing the radio frequency chip 2, and the chip installation part may be located in a roughly central part of the circuit board 1 or in another possible position. The circuit board 1 is provided with a transmit antenna 11 and a receive antenna 12.

In a design, the transmit antenna 11 includes a plurality of transmit antenna modules 11a arranged in a second direction D2, and the receive antenna 12 includes a plurality of receive antenna modules 12a arranged in the second direction D2. In a third direction D3, the transmit antenna 11 and the receive antenna 12 are located on two sides of the chip installation part. In addition, the circuit board 1 is further provided with a feeder 13 extending from the chip installation part and connected to each transmit antenna module 11a and each receive antenna module 12a, and the transmit antenna 11 and the receive antenna 12 are connected to the radio frequency chip 2 through the feeder 13. In another design, the plurality of transmit antenna modules 11a of the transmit antenna 11 are staggered in the third direction D3, or the plurality of receive antenna modules 12a of the receive antenna 12 are staggered in the third direction D3. In still another design, the transmit antenna 11 may include one transmit antenna module 11a, and the receive antenna 12 includes one receive antenna module 12a. In the third direction D3, the transmit antenna 11 and the receive antenna 12 are located on a same side of the chip installation part. In yet another design, the transmit antenna 11 may include a plurality of transmit antenna modules 11a, and the receive antenna 12 includes a plurality of receive antenna modules 12a. The transmit antenna 11 and the receive antenna 12 may be located on a same side of the chip installation part, and the plurality of transmit antenna modules 11a of the transmit antenna 11 and the plurality of receive antenna modules 12a of the receive antenna 12 are alternately arranged in the second direction D2. In other words, an arrangement manner of the transmit antenna 11 and the receive antenna 12 may be adjusted based on a requirement. This is not limited in the solutions of this application.

It should be noted that the feeder 13 in this application does not include a feeder part that forms an antenna, but includes a section of feeder that is led out from the radio frequency chip 2. For example, the feeder 13 is shown in FIG. 4 and FIG. 5. In addition, in actual implementation, various components, such as an antenna, a feeder, and a radio frequency chip, disposed on the circuit board 1 may have a plurality of design manners, and feeders 13 corresponding to these design manners may have different shapes and sizes. A specific component of the feeder 13 is not limited herein.

In this embodiment, as shown in FIG. 4 and FIG. 5, the radio frequency chip 2 (for example, a monolithic microwave integrated circuit MMIC) is installed on the chip installation part of the circuit board 1, and the radio frequency chip 2 is connected to each transmit antenna module 11a and each receive antenna module 12a through the feeder 13 disposed on the circuit board 1. In this way, the radio frequency chip 2 cooperates with the transmit antenna 11 and the receive antenna 12 to implement conversion between an electromagnetic wave (for example, a millimeter wave) transmitted in space and an intra-board high-frequency current, and identify corresponding information.

In this embodiment, as shown in FIG. 3, FIG. 6, and FIG. 7, the wave-absorbing component 3 and the radio frequency chip 2 are located on a same side of the circuit board 1, and the wave-absorbing component 3 is located above the circuit board, and is configured to absorb leaked energy, to improve isolation between channels, thereby reducing interference between the channels. The wave-absorbing component 3 includes a peripheral structure 31 and a wave-absorbing medium 32 accommodated in the peripheral structure 31, and the wave-absorbing medium 32 fills internal space of the peripheral structure 31. The wave-absorbing component 3 is installed and fastened to a part that is of the circuit board 1 and on which the radio frequency chip 2 is disposed. As shown in FIG. 4 and FIG. 5, the wave-absorbing component 3 is located between the transmit antenna 11 and the receive antenna 12, so that the transmit antenna 11 and the receive antenna 12 are located on two sides of the wave-absorbing component 3. Optionally, in a design, when the transmit antenna 11 and the receive antenna 12 are located on a same side of the chip installation part, a part of the wave-absorbing component 3 may be located between the transmit antenna 11 and the receive antenna 12.

As shown in FIG. 4 and FIG. 5, when observation is performed in a first direction D1 perpendicular to the circuit board 1, the wave-absorbing component 3 completely covers the radio frequency chip 2; and when observation is performed in the first direction D1, the wave-absorbing component 3 covers a part of the feeder 13. In this way, the wave-absorbing component 3 can effectively shield the radio frequency chip 2 and the feeder 13, to absorb energy leaked from the radio frequency chip 2 and the feeder 13. In this application, "covering" may be a case in which the wave-absorbing component 3 shields the radio frequency chip 2 from a side (an upper part in FIG. 3, FIG. 6, and FIG. 7) of the first direction D1, or a case in which the wave-absorbing component 3 half-encircles the radio frequency chip 2 and the feeder 13 from an upper part and a side.

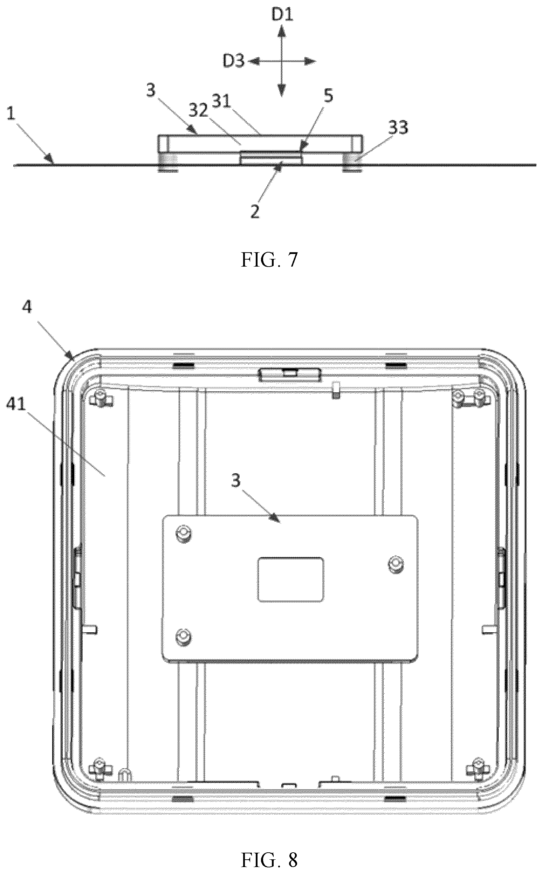

In this embodiment, as shown in FIG. 3 to FIG. 7, a shape of the peripheral structure 31 is a cuboid or an approximate cuboid, and a shape of the space used to accommodate the wave-absorbing medium 32 inside the peripheral structure 31 is a cuboid or an approximate cuboid that is geometrically similar to the shape outside. In an optional design, a thickness direction of the peripheral structure 31 is consistent with the first direction D1, a length direction is consistent with the second direction D2, and a width direction is consistent with the third direction D3. In another design, the length direction and the width direction are perpendicular to each other, and may have a specific angle with the second direction and the third direction respectively. In a further optional design, a fastening hole corresponding to a fastening hole of the circuit board 1 is formed at each of four corners of the peripheral structure 31, and the peripheral structure 31 is fastened to the circuit board 1 through a fastening post that passes through the fastening hole of the peripheral structure 31 and the fastening hole of the circuit board 1 (as shown in FIG. 6 and FIG. 7).

Because a main component of the wave-absorbing medium 32 is water, to ensure that the peripheral structure 31 has high enough sealing performance, the peripheral structure 31 may be made of a hydrophobic material, and an inner surface of the peripheral structure 31 may undergo hydrophobic treatment. The hydrophobic material includes at least one of the following materials: nitrile-butadiene rubber, polytetrafluoroethylene, and silicon dioxide. For hydrophobic treatment, a P2i nanomaterial process can be used. In the P2i nanomaterial process, a pulsed ionized gas (plasma) generated in a vacuum chamber is used to apply a perfluorocarbon polymer to the inner surface or a whole surface of the entire peripheral structure 31. The P2i nanomaterial process significantly reduces surface energy. Therefore, when the inner surface of the peripheral structure 31 is in contact with liquid, the liquid becomes a bead-like body and cannot penetrate the inner surface. In this way, water cannot penetrate the peripheral structure 31 or be absorbed by the peripheral structure 31, and can be sealed inside the peripheral structure 31 for a long time. While ensuring the sealing performance, the peripheral structure 31 forms as much space as possible inside the peripheral structure 31 to accommodate the wave-absorbing medium 32.

Specifically, the wave-absorbing medium may be only water, or the wave-absorbing medium 32 may be a mixed solution of water and ethylene glycol. Water has characteristics of a high dielectric constant and a high loss angle tangent for an electromagnetic wave, and can effectively absorb and consume unrelated energy leaked by the radio frequency chip 2, the feeder 13, and the transmit antenna 11, so that the unrelated energy is weakened or even disappears. Ethylene glycol, as an antifreeze, is mixed with water at a predetermined mass percentage concentration, which can effectively reduce a freezing point of the wave-absorbing medium 32 and support the apparatus to work in a low-temperature environment. In addition, the wave-absorbing medium 32 using the mixed solution of water and ethylene glycol can improve heat dissipation performance of the radio frequency chip 2.

Further, an experiment shows that, if a length, width, or thickness of the wave-absorbing component 3 is insufficient, energy attenuation is insufficient, which causes interference to a channel of the detection apparatus. To effectively improve isolation between channels by using the wave-absorbing component 3, the wave-absorbing component 3 (mainly referring to the peripheral structure 31) should meet a predetermined three-dimensional size requirement.

Specifically, in the second direction D2, the wave-absorbing component 3 extends beyond two ends of the transmit antenna 11 and extends beyond two ends of the receive antenna 12. Considering that a shape and a size of the wave-absorbing medium 32 are limited by using the peripheral structure 31, on any side in the second direction D2, the inner surface (that is, an outer surface of the wave-absorbing medium 32) of the peripheral structure 31 extends beyond a boundary of the radio frequency chip 2 or the feeder 13. Optionally, a length that is of the inner surface (that is, the outer surface of the wave-absorbing medium 32) of the peripheral structure 31 and that extends beyond the boundary of the radio frequency chip 2 or the feeder 13 is greater than or equal to twice a medium wavelength. In this embodiment, correspondingly, a length that is of the inner surface (that is, the outer surface of the wave-absorbing medium 32) of the peripheral structure 31 and that extends beyond one of the radio frequency chip 2 and the feeder 13 that is closer to the outside in the second direction is greater than or equal to twice the medium wavelength. In this way, the wave-absorbing component 3 has a sufficient length. That is, as shown in FIG. 4, in the second direction D2, with the left side used as an example, both a part that is of the feeder 13 and that is connected to the transmit antenna 11 and a part that is of the feeder 13 and that is connected to the receive antenna 12 are closer to the left side than the radio frequency chip 2, that is, the feeder 13 is closer to the outside than the radio frequency chip 2 on the left side. Correspondingly, on the left side of the second direction D2, a size of a part that is of the left side of the outer surface of the wave-absorbing medium 32 and that exceeds a leftmost part of the feeder 13 (the part is a boundary of the feeder 13 on the left side) is greater than or equal to twice a wavelength of an electromagnetic wave transmitted by the detection apparatus. The foregoing size condition is also met on the right side of the second direction D2. To avoid affecting normal operation of the transmit antenna 11 and the receive antenna 12, the wave-absorbing component 3 cannot cover the transmit antenna 11 and the receive antenna 12. Therefore, in the third direction D3, a width of the peripheral structure 31 should not be greater than a minimum spacing between the transmit antenna 11 and the receive antenna 12, and on this basis, the width of the peripheral structure 31 should be as large as possible, so that the wave-absorbing medium has a sufficient width to cover a feeder 13 of a sufficient size. In a variant design of the foregoing embodiment, the transmit antenna 11 and the receive antenna 12 are located on two sides of the wave-absorbing component 3 in the second direction D2, and on any side of the third direction D3, the inner surface (that is, the outer surface of the wave-absorbing medium 32) of the peripheral structure 31 may extend the boundary of the radio frequency chip 2 or the feeder 13. Optionally, a width that is of the inner surface (that is, the outer surface of the wave-absorbing medium 32) of the peripheral structure 31 and that extends beyond the boundary of the radio frequency chip 2 or the feeder 13 is greater than or equal to twice the medium wavelength. In the variant design, it may be understood that, the width that is of the inner surface (that is, the outer surface of the wave-absorbing medium 32) of the peripheral structure 31 and that extends beyond one of the radio frequency chip 2 and the feeder 13 that is closer to the outside is greater than or equal to twice the wavelength of the electromagnetic wave transmitted by the detection apparatus. For the size condition herein, refer to the foregoing explanation described in the foregoing embodiment. Further, optionally, in the first direction D1, a minimum thickness of the wave-absorbing medium 32 is greater than or equal to 1/2 of the wavelength of the electromagnetic wave transmitted by the detection apparatus. Further, optionally, in the first direction D1, a maximum distance between outer surfaces that are of the wave-absorbing medium 32 and the circuit board 1 and that face each other is less than or equal to 1/4 of the wavelength. That is, in this embodiment, as shown in FIG. 3, FIG. 6, and FIG. 7, in the first direction D1, a maximum distance between a lower surface of the wave-absorbing medium 32 and an upper surface of the circuit board 1 is less than or equal to 1/4 of the wavelength. According to the foregoing size design, the wave-absorbing component 3 has effect of "a barrier wall", thereby effectively attenuating leaked energy and improving isolation between channels.

In this embodiment, as shown in FIG. 1 to FIG. 3, the radome 4 is configured to cover the circuit board 1 and the radio frequency chip 2, the wave-absorbing component 3, and the like disposed on the circuit board 1.

In this embodiment, as shown in FIG. 3, FIG. 6, and FIG. 7, the heat conducting component 5 is disposed between the radio frequency chip 2 and the wave-absorbing component 3, and the heat conducting component 5 is in direct contact with the radio frequency chip 2, so that heat generated by the radio frequency chip 2 can be transferred to the wave-absorbing component 3 through the heat conducting component 5. Specifically, the heat conducting component 5 includes a steel sheet and a heat conducting gel. The steel sheet is embedded into a part that is of the peripheral structure 31 and that is in contact with the radio frequency chip 2 in an in-film injection molding manner. The heat conducting gel is added between the steel sheet and the radio frequency chip 2. The heat conducting component 5 can significantly improve a heat dissipation capability of the radio frequency chip 2. In addition, the steel sheet further improves rigidity of the wave-absorbing component 3 at a part corresponding to the radio frequency chip 2. In this way, when the detection apparatus is under unexpected pressure, the steel sheet can prevent the radio frequency chip 2 from being affected by the unexpected pressure.

The following describes a structure of a detection apparatus according to a second embodiment of this application with reference to the accompanying drawings.

### (Structure of the detection apparatus according to the second embodiment of this application)

The structure of the detection apparatus according to the second embodiment of this application is basically the same as the structure of the detection apparatus according to the first embodiment of this application. The following describes a difference between the two.

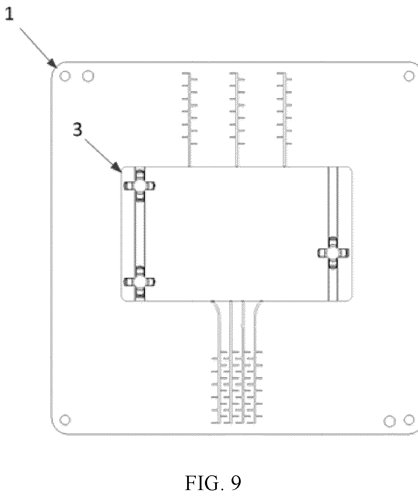

In this embodiment, as shown in FIG. 8 and FIG. 9, the wave-absorbing component 3 is fastened to the radome 4. Specifically, the wave-absorbing component 3 may be independently formed and fastened to the radome 4, or the wave-absorbing component 3 may be integrated with another part of the radome 4. In this embodiment, the wave-absorbing component 3 also covers the radio frequency chip 2 and the feeder 13, and is located between the transmit antenna 11 and the receive antenna 12. In addition, except for a part used to fasten the wave-absorbing component 3, the other part of the radome 4 is used as a wave transmission part 41. An electromagnetic wave can be transmitted through the wave transmission part 41, and an electromagnetic wave from the outside can be received through the wave transmission part 41, so that normal operation of the detection apparatus is not affected.

The foregoing describes the example embodiments of this application, and the following provides supplementary descriptions.
i. Although no specific description is provided in the specific implementation, it should be understood that the circuit board 1 may be provided with a plurality of receive antennas and a plurality of transmit antennas. The wave-absorbing component 3 may not form a cuboid shape, but form a special shape based on a requirement, so that a part of the wave-absorbing component may be located between two adjacent receive antennas, and the other part of the wave-absorbing component may be located between two adjacent transmit antennas.
ii. Although it is described in the specific implementation that the peripheral structure 31 is fastened to the circuit board 1 in a manner of being spaced away from the circuit board 1, this application is not limited thereto. For example, the following technical solution may be used.

A concave part that accommodates the radio frequency chip 2 is formed at a part that is of the peripheral structure 31 and that corresponds to the radio frequency chip 2, and a specific interval is further formed between the peripheral structure 31 and the feeder 13. Further, a gapless "zero fitting" is used between the peripheral structure 31 and a part of the circuit board 1 except the radio frequency chip 2 and the feeder 13, to suppress a surface wave excited by the transmit antenna 11 on the circuit board 1. In this case, in order not to affect normal operation of the feeder 13, the transmit antenna 11, and the receive antenna 12, the wave-absorbing component 3 is spaced from a part that is of the circuit board 1 and at which the feeder 13 is formed, and is spaced from antenna radiation units of the transmit antenna 11 and the receive antenna 12. The antenna radiation unit is a minimum working unit of the transmit antenna 11 or the receive antenna 12, and can effectively transmit and receive an electromagnetic wave.

iii. Although not explicitly stated in the specific embodiment, it should be understood that the mass percentage concentration between the ethylene glycol and the water in the wave-absorbing medium 32 may be adjusted as required. A test shows that when the mass percentage concentration of the ethylene glycol in the wave-absorbing medium 32 is 54%, an ice point of the wave-absorbing medium 32 is -40 degrees Celsius; and when the mass percentage concentration of the ethylene glycol in the wave-absorbing medium 32 is 60%, the ice point of the wave-absorbing medium 32 is -48.3 degrees Celsius. In an optional design, the mass percentage concentration of the ethylene glycol in the wave-absorbing medium 32 is not greater than 60%. In this way, ethylene glycol mixture in the wave-absorbing medium 32 does not freeze in a low temperature environment, and the wave-absorbing medium 32 can still maintain a liquid state and maintain absorption effect on an electromagnetic wave. In addition, in some environments where temperature is not lower than zero degrees, the wave-absorbing medium 32 may be made up of water and does not include ethylene glycol.

iv. Although it is described in the specific implementation that the transmit antenna 11 and the receive antenna 12 are disposed on two sides of the radio frequency chip 2, this application is not limited thereto. For example, the transmit antenna 11 and the receive antenna 12 may be disposed on a same side of the radio frequency chip 2. In this case, the wave-absorbing component 3 may use another shape and structure, to cover the radio frequency chip 2 and the feeder 13 and be disposed between the transmit antenna 11 and the receive antenna 12.

v. In this application, the following beneficial effect may be obtained by using the technical solutions of this application:
(1) Water is used as the wave-absorbing medium to effectively absorb energy leaked by the radio frequency chip and the feeder, improve isolation between the transmit channels, the receive channels, and the receive channel and the transmit channel of the detection apparatus, prevent antenna pattern distortion, reduce interference to the receive channel and the transmit channel, ensure a receiver sensitivity and noise figure, and improve competitiveness of the entire system.
(2) The detection apparatus is highly compatible with antenna design solutions, and can be adjusted based on different antenna solutions, to be quickly iterated and optimized with little impact on the antenna performance and radiation pattern.
(3) Low-cost and easy-to-obtain water is used as a wave-absorbing material, thereby reducing dependence on a specific wave-absorbing material, and wave-absorbing effect is obvious. The water further has good heat dissipation and cooling effect on the radio frequency chip 2, and allows the chip to work in a higher wave-transmitting duty cycle state, thereby improving a detection signal-to-noise ratio.
(4) A material selected for the peripheral structure 31 of the wave-absorbing assembly 3 has a thermoplastic attribute, can be manufactured in batches by opening a mold, and has low assembly costs, and is suitable for batch assembly and production in a production line.
(5) The structure of a wave absorption area is simple, an area is small, and is conducive for system integration.

vi. Not explicitly described in the foregoing specific implementation, this application further provides a millimeter-wave radar, including the detection apparatus described in various embodiments described in the foregoing specific implementation.

Further, this application further provides a terminal device, including the detection apparatus described in the foregoing embodiments described in the specific implementations. Further, the terminal device may be an intelligent transportation device (for example, an auto-driving system and a road monitoring system), a smart home device, an intelligent manufacturing device, an uncrewed aerial vehicle, or a robot, but is not limited to the foregoing device and machine. Instead, the detection apparatus in this application may be applied to various other devices based on a requirement.

Although this application is described with reference to embodiments, in a process of implementing this application that claims protection, a person skilled in the art may understand and implement another variation of the disclosed embodiments by viewing the accompanying drawings, disclosed content, and the accompanying claims. In the claims, "comprising" does not exclude another component or another step, and "a" or "one" does not exclude a meaning of plurality. Some measures are recorded in dependent claims that are different from each other, but this does not mean that these measures cannot be combined to produce a better effect.

Embodiments of this application are described above. The foregoing descriptions are examples, not exhaustive, and not limited to the foregoing disclosed embodiments. Many modifications and variations are apparent to a person of ordinary skill in the art without departing from the scope of the described embodiments. Selection of terms used in this specification is intended to best explain embodiment principles, actual application or improvements to technologies in the market, or to enable another person of ordinary skill in the art to understand the embodiments disclosed in this specification.

## Claims

1. A detection apparatus, comprising a circuit board (1) and a radio frequency chip (2), wherein the radio frequency chip (2) is installed on the circuit board (1), the circuit board (1) is provided with a transmit antenna (11), a receive antenna (12), and a feeder (13), and the transmit antenna (11) and the receive antenna (12) are connected to the radio frequency chip (2) through the feeder (13), wherein
the detection apparatus further comprises a wave-absorbing component (3), wherein the wave-absorbing component (3) and the radio frequency chip (2) are located on a same side of the circuit board (1);
in a first direction perpendicular to the circuit board (1), the wave-absorbing component (3) covers the radio frequency chip (2); and
the wave-absorbing component (3) comprises a peripheral structure (31) and a wave-absorbing medium (32) encircled and accommodated by the peripheral structure (31), and the wave-absorbing medium (32) comprises water.

2. The detection apparatus according to claim 1, wherein in the first direction, the wave-absorbing component (3) covers a part (41) or all of the feeder (13).

3. The detection apparatus according to claim 1 or 2, wherein in the first direction, a minimum thickness of the wave-absorbing medium (32) is greater than or equal to 1/2 of a medium wavelength, and the medium wavelength is a wavelength that is of an electromagnetic wave transmitted by the detection apparatus and that is in the circuit board (1).

4. The detection apparatus according to any one of claims 1 to 3, wherein in the first direction, a maximum distance between outer surfaces that are of the wave-absorbing medium (32) and the circuit board (1) and that face each other is less than or equal to 1/4 of the medium wavelength.

5. The detection apparatus according to any one of claims 1 to 4, wherein
on any side in a second direction, the outer surface of the wave-absorbing medium (32) exceeds a boundary of the radio frequency chip (2) or the feeder (13); and/or
on any side in a third direction, the outer surface of the wave-absorbing medium (32) exceeds the boundary of the radio frequency chip (2) or the feeder (13), wherein
the second direction and the third direction are parallel to the circuit board (1), and the second direction is perpendicular to the third direction.

6. The detection apparatus according to any one of claims 1 to 5, wherein the wave-absorbing component (3) is located between the receive antenna (12) and the transmit antenna (11).

7. The detection apparatus according to any one of claims 1 to 6, wherein the circuit board (1) comprises a plurality of receive antennas (12) and a plurality of transmit antennas (11);
a part (41) of the wave-absorbing component (3) is located between two adjacent receive antennas (12); and/or
a part (41) of the wave-absorbing component (3) is located between two adjacent transmit antennas (11).

8. The detection apparatus according to any one of claims 1 to 7, wherein the peripheral structure (31) is made of a hydrophobic material.

9. The detection apparatus according to claim 8, wherein the hydrophobic material comprises at least one of the following materials: nitrile-butadiene rubber, polytetrafluoroethylene, and silicon dioxide.

10. The detection apparatus according to any one of claims 1 to 9, wherein the wave-absorbing medium (32) further comprises ethylene glycol.

11. The detection apparatus according to any one of claims 1 to 10, wherein the detection apparatus further comprises a heat conducting component (5), the heat conducting component (5) is disposed between the wave-absorbing component (3) and the radio frequency chip (2), and the heat conducting component (5) is in contact with the radio frequency chip (2).

12. The detection apparatus according to claim 11, wherein the heat conducting component (5) comprises at least one of a metal sheet and a heat conducting medium.

13. The detection apparatus according to any one of claims 1 to 12, wherein the detection apparatus is a millimeter-wave detection apparatus.

14. A millimeter-wave radar, wherein the millimeter-wave radar comprises the detection apparatus according to any one of claims 1 to 13.

## Patentansprüche

1. Erkennungseinrichtung, die eine Leiterplatte (1) und einen Hochfrequenzchip (2) umfasst, wobei der Hochfrequenzchip (2) auf der Leiterplatte (1) installiert ist, wobei die Leiterplatte (1) mit einer Sendeantenne (11), einer Empfangsantenne (12) und einer Zuleitung (13) bereitgestellt wird und wobei die Sendeantenne (11) und die Empfangsantenne (12) durch die Zuleitung (13) mit dem Hochfrequenzchip (2) verbunden sind, wobei:
die Erkennungseinrichtung ferner eine wellenabsorbierende Komponente (3) umfasst, wobei sich die wellenabsorbierende Komponente (3) und der Hochfrequenzchip (2) auf einer gleichen Seite der Leiterplatte (1) befinden;
die wellenabsorbierende Komponente (3) den Hochfrequenzchip (2) in einer ersten Richtung senkrecht zu der Leiterplatte (1) bedeckt; und
die wellenabsorbierende Komponente (3) aus einer peripheren Struktur (31) und einem wellenabsorbierenden Medium (32) besteht, das von der peripheren Struktur (31) umschlossen und untergebracht wird, und wobei das wellenabsorbierende Medium (32) Wasser umfasst.

2. Erkennungseinrichtung nach Anspruch 1, wobei die wellenabsorbierende Komponente (3) in der ersten Richtung einen Teil (41) der oder die gesamte Zuleitung (13) bedeckt.

3. Erkennungseinrichtung nach Anspruch 1 oder 2, wobei eine minimale Dicke des wellenabsorbierenden Mediums (32) in der ersten Richtung größer als ein oder gleich einem 1/2 von einer mittleren Wellenlänge ist und wobei die mittlere Wellenlänge eine Wellenlänge ist, die zu einer elektromagnetischen Welle gehört, die von der Erkennungseinrichtung übertragen wird und die sich in der Leiterplatte (1) befindet.

4. Erkennungseinrichtung nach einem der Ansprüche 1 bis 3, wobei ein maximaler Abstand zwischen Außenflächen, die zu dem wellenabsorbierenden Medium (32) gehören, und der Leiterplatte (1), und die einander zugewandt sind, in der ersten Richtung kleiner als ein oder gleich einem 1/4 der mittleren Wellenlänge ist.

5. Erkennungseinrichtung nach einem der Ansprüche 1 bis 4, wobei
die Außenfläche des wellenabsorbierenden Mediums (32) auf jeder Seite eine Grenze des Hochfrequenzchips (2) oder der Zuleitung (13) in einer zweiten Richtung überschreitet; und/oder
die Außenfläche des wellenabsorbierenden Mediums (32) auf jeder Seite die Grenze des Hochfrequenzchips (2) oder der Zuleitung (13) in einer dritten Richtung überschreitet, wobei
die zweite Richtung und die dritte Richtung parallel zu der Leiterplatte (1) sind, und die zweite Richtung senkrecht zur dritten Richtung steht.

6. Erkennungseinrichtung nach einem der Ansprüche 1 bis 5, wobei sich die wellenabsorbierende Komponente (3) zwischen der Empfangsantenne (12) und der Sendeantenne (11) befindet.

7. Erkennungseinrichtung nach einem der Ansprüche 1 bis 6, wobei die Leiterplatte (1) eine Vielzahl von Empfangsantennen (12) und eine Vielzahl von Sendeantennen (11) umfasst;
wobei sich ein Teil (41) der wellenabsorbierenden Komponente (3) zwischen zwei benachbarten Empfangsantennen (12) befindet; und/oder
wobei sich ein Teil (41) der wellenabsorbierenden Komponente (3) zwischen zwei benachbarten Sendeantennen (11) befindet.

8. Erkennungseinrichtung nach einem der Ansprüche 1 bis 7, wobei die periphere Struktur (31) aus einem hydrophoben Material gefertigt ist.

9. Erkennungseinrichtung nach Anspruch 8, wobei das hydrophobe Material mindestens eines der folgenden Materialien umfasst: Nitril-Butadien-Kautschuk, Polytetrafluorethylen und Siliciumdioxid.

10. Erkennungseinrichtung nach einem der Ansprüche 1 bis 9, wobei das wellenabsorbierende Medium (32) ferner Ethylenglykol umfasst.

11. Erkennungseinrichtung nach einem der Ansprüche 1 bis 10, wobei die Erkennungseinrichtung ferner eine wärmeleitende Komponente (5) umfasst, wobei die wärmeleitende Komponente (5) zwischen der wellenabsorbierenden Komponente (3) und dem Hochfrequenzchip (2) angeordnet ist und wobei die wärmeleitende Komponente (5) in einem Kontakt mit dem Hochfrequenzchip (2) steht.

12. Erkennungseinrichtung nach Anspruch 11, wobei die wärmeleitende Komponente (5) mindestens eines von einer Metallfolie und einem wärmeleitenden Medium umfasst.

13. Erkennungseinrichtung nach einem der Ansprüche 1 bis 12, wobei die Erkennungseinrichtung eine Millimeterwellen-Erkennungseinrichtung ist.

14. Millimeterwellen-Radar, wobei das Millimeterwellen-Radar die Erkennungseinrichtung nach einem der Ansprüche 1 bis 13 umfasst.

## Revendications

1. Appareil de détection comprenant une carte de circuit (1) et une puce radiofréquence (2), la puce radiofréquence (2) étant installée sur la carte de circuit (1), la carte de circuit (1) étant pourvue d'une antenne d'émission (11), d'une antenne de réception (12) et d'un dispositif d'alimentation (13), et l'antenne d'émission (11) et l'antenne de réception (12) étant connectées à la puce radiofréquence (2) par l'intermédiaire du dispositif d'alimentation (13), dans lequel
l'appareil de détection comprend en outre un composant absorbant les ondes (3), le composant absorbant les ondes (3) et la puce radiofréquence (2) étant situés d'un même côté de la carte de circuit (1) ;
dans une première direction perpendiculaire à la carte de circuit (1), le composant absorbant les ondes (3) recouvre la puce radiofréquence (2) ; et
le composant absorbant les ondes (3) comprend une structure périphérique (31) et un milieu absorbant les ondes (32) entouré et logé dans la structure périphérique (31), et le milieu absorbant les ondes (32) comprend de l'eau.

2. Appareil de détection selon la revendication 1, dans lequel, dans la première direction, le composant absorbant les ondes (3) recouvre une partie (41) ou la totalité du dispositif d'alimentation (13).

3. Appareil de détection selon la revendication 1 ou 2, dans lequel, dans la première direction, une épaisseur minimale du milieu absorbant les ondes (32) est supérieure ou égale à 1/2 d'une longueur d'onde moyenne, et la longueur d'onde moyenne est une longueur d'onde d'une onde électromagnétique émise par l'appareil de détection et qui est dans la carte de circuit (1).

4. Appareil de détection selon l'une quelconque des revendications 1 à 3, dans lequel, dans la première direction, une distance maximale entre des surfaces extérieures du milieu absorbant les ondes (32) et de la carte de circuit (1) qui se font face est inférieure ou égale à 1/4 de la longueur d'onde moyenne.

5. Appareil de détection selon l'une quelconque des revendications 1 à 4, dans lequel
sur un côté quelconque dans une deuxième direction, la surface extérieure du milieu absorbant les ondes (32) dépasse une limite de la puce radiofréquence (2) ou du dispositif d'alimentation (13) ; et/ou
sur un côté quelconque dans une troisième direction, la surface extérieure du milieu absorbant les ondes (32) dépasse la limite de la puce radiofréquence (2) ou du dispositif d'alimentation (13), dans lequel
la deuxième direction et la troisième direction sont parallèles à la carte de circuit imprimé (1), et la deuxième direction est perpendiculaire à la troisième direction.

6. Appareil de détection selon l'une quelconque des revendications 1 à 5, dans lequel le composant absorbant les ondes (3) est situé entre l'antenne de réception (12) et l'antenne d'émission (11).

7. Appareil de détection selon l'une quelconque des revendications 1 à 6, dans lequel la carte de circuit (1) comprend une pluralité d'antennes de réception (12) et une pluralité d'antennes d'émission (11) ;
une partie (41) du composant absorbant les ondes (3) est située entre deux antennes de réception (12) adjacentes ; et/ou
une partie (41) du composant absorbant les ondes (3) est située entre deux antennes d'émission (11) adjacentes.

8. Appareil de détection selon l'une quelconque des revendications 1 à 7, dans lequel la structure périphérique (31) est faite d'un matériau hydrophobe.

9. Appareil de détection selon la revendication 8, dans lequel le matériau hydrophobe comprend au moins l'un des matériaux suivants : caoutchouc nitrile-butadiène, polytétrafluoroéthylène et dioxyde de silicium.

10. Appareil de détection selon l'une quelconque des revendications 1 à 9, dans lequel le milieu absorbant les ondes (32) comprend en outre de l'éthylène glycol.

11. Appareil de détection selon l'une quelconque des revendications 1 à 10, dans lequel l'appareil de détection comprend en outre un composant conducteur de chaleur (5), le composant conducteur de chaleur (5) est disposé entre le composant absorbant les ondes (3) et la puce radiofréquence (2), et le composant conducteur de chaleur (5) est en contact avec la puce radiofréquence (2).

12. Appareil de détection selon la revendication 11, dans lequel le composant conducteur de chaleur (5) comprend au moins l'un d'une feuille métallique et d'un milieu conducteur de chaleur.

13. Appareil de détection selon l'une quelconque des revendications 1 à 12, dans lequel l'appareil de détection est un appareil de détection à ondes millimétriques.

14. Radar à ondes millimétriques, dans lequel le radar à ondes millimétriques comprend l'appareil de détection selon l'une quelconque des revendications 1 à 13.
